Europäisches Patentamt

European Patent Office

Office européen des brevets

(19)

(11) Veröffentlichungsnummer : **0 009 562**
**B1**

(12) **EUROPÄISCHE PATENTSCHRIFT**

(45) Veröffentlichungstag der Patentschrift :
21.07.82

(21) Anmeldenummer : 79102721.2

(22) Anmeldetag : 31.07.79

(51) Int. Cl.³ : **H 01 L 21/263, H 01 L 21/423,
H 01 J 37/30**

(54) Verfahren und Vorrichtung zur Belichtung durch Korpuskularstrahlen-Schattenwurf.

(30) Priorität : 29.08.78 DE 2837590

(43) Veröffentlichungstag der Anmeldung :
16.04.80 (Patentblatt 80/08)

(45) Bekanntmachung des Hinweises auf die Patenterteilung : 21.07.82 Patentblatt 82/29

(84) Benannte Vertragsstaaten :
DE FR GB

(56) Entgegenhaltungen :
EP - A - 0 001 042
DE - A - 2 056 620
DE - A - 2 547 079
DE - A - 2 739 502

ELEKTRONIK 1977, Heft 8, August 1977, Franzisverlag GmbH, München, CHANG u.a. : « Grundlagen und Technik der Elektronenstrahl-Lithographie » seiten 51-60

ELEKTRONIKER Nr. 2/1979, Februar 1979, AT
Fachschriftenverlag Elektroniker, Aarau,
Schaumburg : « Lithographietechniken für
höchstintegrierte Schaltungen » Seiten EL 41 -
EL 43

ELECTRONICS, May 12, 1977, Mc Graw Hill, New
York, « Philips develops mask projection system
with alignment accuracy to 0.1 micrometer » Seiten 32, 33

ELECTRONICS, May 12, 1977, Mc Graw Hill, New
York, CHANG u.a. : « Electron-beam lithography
draws a finer line », Seiten 89-98

(73) Patentinhaber : International Business Machines Corporation

Armonk, N.Y. 10504 (US)

(72) Erfinder : Bohlen, Harald
Geleener Strasse 26
D-7030 Böblingen (DE)
Erfinder : Engelke, Helmut, Dr.
Ahornweg 33
D-7031 Altdorf (DE)
Erfinder : Greschner, Johann, Dr.
Zollernstrasse 14
D-7401 Pliezhausen (DE)
Erfinder : Kulcke, Werner, Dr.
Westerwaldweg 8
D-7030 Böblingen (DE)
Erfinder : Nehmiz, Peter, Dr.
Adlerstrasse 7
D-7030 Böblingen (DE)

(74) Vertreter : Teufel, Fritz, Dipl.-Phys.
Schönaicher Strasse 220
D-7030 Böblingen (DE)

(56) Entgegenhaltungen :
ELECTRONICS, November 10, 1977, Mc Graw
Hill, New York, WEBER, YOURKE : « Scanning
electron-beam system turns out IC wafers fast »
Seiten 96-101

IBM J. RES. DEVELOPMENT, November 1977,
New York, DAVIS u.a. : « Automatic Registration
in an Electron-Beam Lithographic System » Seiten 498-505

IBM J. RES. DEVELOPMENT, November 1977, New York, ENGELKE u.a. : « Correction of Nonlinear Deflection Distortion in a Direct Exposure Electron-Beam System », Seiten 506-513

IBM J. RES. DEVELOPMENT, November 1977, New York, MAUER u.a. : « Electron Optics of an Electron-Beam Lithographic System », Seiten 514-521

## Verfahren und Vorrichtung zur Belichtung durch Korpuskularstrahlen-Schattenwurf

Die Erfindung betrifft Verfahren zur Belichtung strahlungsempfindlicher Schichten sowie Vorrichtungen zur Durchführung des Verfahren. Sie eignet sich insbesondere zur Belichtung von mit einer Photolackschicht überzogenen Halbleiterplättchen durch Komplementärmasken unter Verwendung von Elektronenstrahlen bei der Herstellung von integrierten Halbleiterschaltungen, deren Leiterzüge und Schaltelemente im Submikronbereich liegende Abmessungen aufweisen.

Bei der Herstellung von integrierten Halbleiterschaltungen werden die in einer Vielzahl von aufeinanderfolgenden Verfahrensschritten mit Leiterzügen zu versehenden, mit bestimmten Substanzen zu dotierenden oder sonstwie zu behandelnden Bereiche eines Halbleiterplättchens dadurch definiert, daß die Halbleiterplättchen mit einer Photolackschicht überzogen werden und diese mit Hilfe von Masken durch Projektionsdruck oder durch Schattenwurfverfahren mit bestimmten Lichtmustern beaufschlagt werden.

Es ist einleuchtend, daß bei den bisher kleinsten mit optischen Belichtungsverfahren erzielbaren Linienbreiten von etwa 2 µm die Ausrichtung der in aufeinanderfolgenden Verfahrensschritten verwendeten Masken auf in vorhergehenden Verfahrensschritten aufgebrachte Elemente mit einer Genauigkeit von mindestens einem Viertel der obengenannten Linienbreiten, d.h. mit einer Genauigkeit von rund 0,5 µm erfolgen müßte. Im Zuge der ständigen Entwicklung der integrierten Halbleiterschaltungen nach immer höherer Miniaturisierung wurde die bei etwa 2 µm liegende Grenze des Auflösungsvermögens aller bekannter optischer Verfahren erreicht. Eine weitere Erhöhung der Packungsdichte war nur mit Röntgen- oder Elektronenstrahlenverfahren möglich, mit denen theoretische Linienbreiten von 0,1 µm und weniger erreichbar sind. Die bei diesem Miniaturisierungsgrad bei der Ausrichtung der Masken in bezug auf die Halbleiterplättchen entstehenden Probleme konnten mit den herkömmlichen Verfahren in wirtschaftlich befriedigender Weise nicht gelöst werden. Besondere Schwierigkeiten treten bei Verwendung der bei der Belichtung mit Elektronenstrahlen vorwiegend verwendeten Komplementärmasken auf, bei deren Verwendung um den Faktor zwei bis drei höhere Ausrichtgenauigkeiten erforderlich werden.

Da es keine für Elektronenstrahlen oder andere Korpuskularstrahlen durchsichtige Trägerschichten gibt, können Masken zur Belichtung durch Elektronenstrahlen nur relativ einfache, aus isolierten Löchern bestehende Elemente enthalten. Daher werden zur Elektronenstrahlbelichtung sogenannte Komplementärmasken verwendet, die jeweils nur Teilmuster enthalten, deren Kombination die gewünschten Gesamtmuster ergibt. Es ist einleuchtend, daß die Halbleiterplättchen nach jeder Belichtung eines Teilmusters verschoben und erneut ausgerichtet werden müssen. Da jedes Teilmuster jeweils nur einen Bruchteil des Gesamtmusters enthält — in der Regel also aus Elementen besteht, deren Abmessungen kleiner als die Elemente der Gesamtmuster sind — werden an die Ausrichtgenauigkeit entsprechend höhere Anforderungen gestellt. Die auf diese Weise erforderlich werdenden Verschiebungen zur Verwirklichung der Ausrichtgenauigkeiten von 0,025 µm können durch mechanische Mittel zumindest mit vertretbarem apparativen und zeitlichen Aufwand nicht durchgeführt werden.

In der älteren europäischen Anmeldung 0001042 wird ein Verfahren zur Belichtung durch Korpuskularstrahlenschattenwurf unter Verwendung von Komplementärmasken beschrieben, bei dem die Ausrichtung der Maske in bezug auf das Halbleiterplättchen durch eine aus einer körperlichen Verschiebung des Halbleiterplättchens in bezug auf die Maske bestehenden Grobausrichtung und einer dieser folgenden Feinausrichtung besteht, bei der der belichtende Korpuskularstrahl, dessen Querschnitt mindestens gleich der bei einer bestimmten Relativlage zwischen Maske und Halbleiterplättchen zu belichtenden Fläche ist, zur seitlichen Verschiebung seines Auftreffpunktes auf dem Halbleiterplättchen um einen bestimmten Winkel gekippt wird.

Wie leicht einzusehen ist, können bei diesem Verfahren durch die Kippung des Korpuskularstrahls nur Ausrichtfehler in X- und/oder Y-Richtung kompensiert werden, die sich über den gesamten bei einer bestimmten Relativlage zwischen Maske und Halbleiterplättchen zu belichtenden Bereich erstrecken. Ausrichtfehler, die durch eine Rotation der Maske in bezug auf das Halbleiterplättchen, durch Verzerrungen des Halbleiterplättchens, durch örtliche Längenänderungen von Maske oder Halbleiterplättchen oder durch örtliche Änderungen des Abstandes zwischen Maske und Halbleiterplättchen bedingt sind, können mit diesem Verfahren nicht kompensiert werden.

Die Erfindung geht von der Aufgabe aus, bei Verfahren der oben beschriebenen Art Ausrichtfehler zu kompensieren, die nicht nur durch translatorische seitliche Versetzungen des gesamten, bei einer bestimmten Relativlage zwischen Maske und Halbleiterplättchen zu belichtenden Bereiches, sondern auch durch Drehungen der Maske in bezug auf das Halbleiterplättchen, durch örtliche Längenänderungen der Maske und/oder des Halbleiterplättchens und durch örtliche Änderungen des Abstandes zwischen Maske und Halbleiterplättchen bedingt sind.

Diese Aufgabe wird durch die im Anspruch angegebenen Verfahrensschritte gelöst.

Da bei der Belichtung von Halbleiterplättchen bei der Herstellung von integrierten Schaltungen in der Regel alle der obengenannten Ausrichtfehler auftreten können, ist es mit den zum Stande der Technik gehörenden sowie mit den in der obengenannten Patentanmeldung beschriebenen Verfahren nicht möglich, integrierte Halbleiterschaltungen im Submikronbereich rationell zu fertigen. Da gemäß vorliegender Erfindung der bei einer bestimmten Relativlage zwischen Maske und Halbleiterplättchen durch Schattenwurf zu übertragende Bereich nicht durch einmalige Belichtung dieses Bereiches sondern durch rasterförmige Beaufschlagung einzelner, vorzugsweise punktförmiger Teilbereiche erfolgt, können alle oben beschriebenen Ausrichtfehler dadurch ohne nennenswerten apparativen und zeitlichen Mehraufwand kompensiert werden, daß die Ausrichtgenauigkeit möglichst vieler und möglichst kleiner Teilbereiche entweder untersucht oder anhand weniger Messungen errechnet wird und dann die für die Ausrichtfehler der einzelnen Teilbereiche erforderlichen Kippungen des Korpuskularstrahls automatisch durchgeführt werden. Handelt es sich hingegen nur um durch Translation und Rotation bedingte Ausrichtfehler — eine Begrenzung, die man bei geeigneter Führung des Prozesses und Wahl der Randbedingungen relativ leicht einhalten kann, so genügt es, wenn die Ausrichtgenauigkeit nur relativ selten, also nur je einmal für relativ große Bereiche festgestellt wird und die dann für jeden Teilbereich erforderlichen Korrekturgrößen rechnerisch ermittelt werden. Dies kann besonders anschaulich für den Fall eines im Mittelpunkt vollkommen ausgerichteten Bereichs erläutert werden, der aber einen Torsionsausrichtfehler hat. Da, wie leicht einzusehen, dieser Fehler bei Wahl genügend kleiner Teilbereiche in diesen Teilbereichen jeweils nur als Translationsfehler wirksam wird, der proportional der Entfernung des jeweiligen Teilbereichs vom Torsionsmittelpunkt ist, lassen sich anhand weniger Messungen, beispielsweise an in den vier Ecken des Bereichs angeordneten Ausrichtmarkierungen, tausende von Translationsfehlern für die einzelnen Teilbereiche sowie die zu ihrer jeweiligen Kompensation erforderlichen Kippwinkel errechnen.

Durch die vorliegende Erfindung werden die Schwierigkeiten behoben, die bei der Herstellung von integrierten Halbleiterschaltungen im Submikronbereich vor allem darin lagen, daß bei Verwendung von Korpuskularstrahlen Ausrichtfehler zwar mit ausreichender Genauigkeit festgestellt werden konnten, ihre Behebung durch Translations- und/oder Rotationsbewegungen in der Größenordnung von 0,1 µm und darunter bzw. Bruchteilen von Bogensekunden, wenn überhaupt so, nur mit einem sehr hohen apparativen und zeitlichen Aufwand möglich war. Diese Tatsache war bisher ein wesentliches Hindernis für die Verwendung der Elektronenstrahllithographie bei der Herstellung von integrierten Halbleiterschaltungen mit Leiterzügen und Schaltelementen, deren Durchmesser im Submikronbereich lag.

Ein Ausführungsbeispiel der Erfindung wird anschließend anhand der Fign. näher erläutert. Es zeigen :

Figur 1 die schematische Darstellung eines Ausführungsbeispiels der Erfindung,

Figur 2 eine Draufsicht auf den Kreuzsupport der in Fig. 1 dargestellten Vorrichtung,

Figure 3, 4 und 5 Darstellungen verschiedener Ausrichtfehler,

Figur 6 ein Abtastschema.

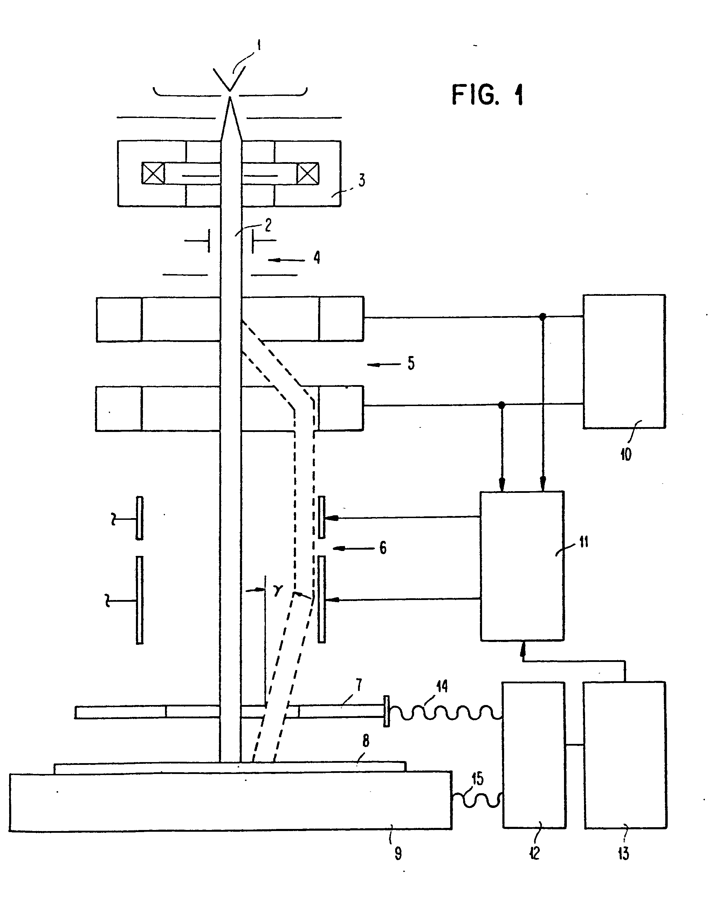

Das in Fig. 1 dargestellte Ausführungsbeispiel besteht aus einer Elektronenstrahlquelle 1 zur Erzeugung eines Elektronenstrahls 2, einer Kollimatorlinse 3, einer Vorrichtung 4 zur Austastung des Elektronenstrahls, einer elektromagnetischen Ablenkvorrichtung 5 zur steuerbaren Parallelverschiebung des Elektronenstrahls, einer elektrostatischen oder elektromagnetischen Ablenkvorrichtung 6 zur Kippung des Elektronenstrahls um einen in oder in der Nähe der Maske 7 liegenden Punkt, einen Kreuzsupport 9 zur Aufnahme eines zu belichtenden Halbleiterplättchens 8, einen Rastergenerator 10 zur Steuerung der elektromagnetischen Ablenkvorrichtung 5 zur Erzeugung einer eine rasterförmige Abtastung bewirkenden Strahlablenkung, einen Kippgenerator 11 zur steuerbaren Kippung des Elektronenstrahls 2 um einen in oder in der Nähe der Ebene der Maske 7 liegenden Punkt, einer Interferometeranordnung 12 zur Überwachung der Lage der Maske 7 und des Kreuzsupports 9 sowie aus einem Computer 13, der die durch die Interferometeranordung 12 festgestellten Ausrichtfehler zwischen der Maske 7 und dem auf dem Kreuzsupport 9 angeordneten Halbleiterplättchen 8 in Steuerbefehle für den Kippgenerator 11 umwandelt.

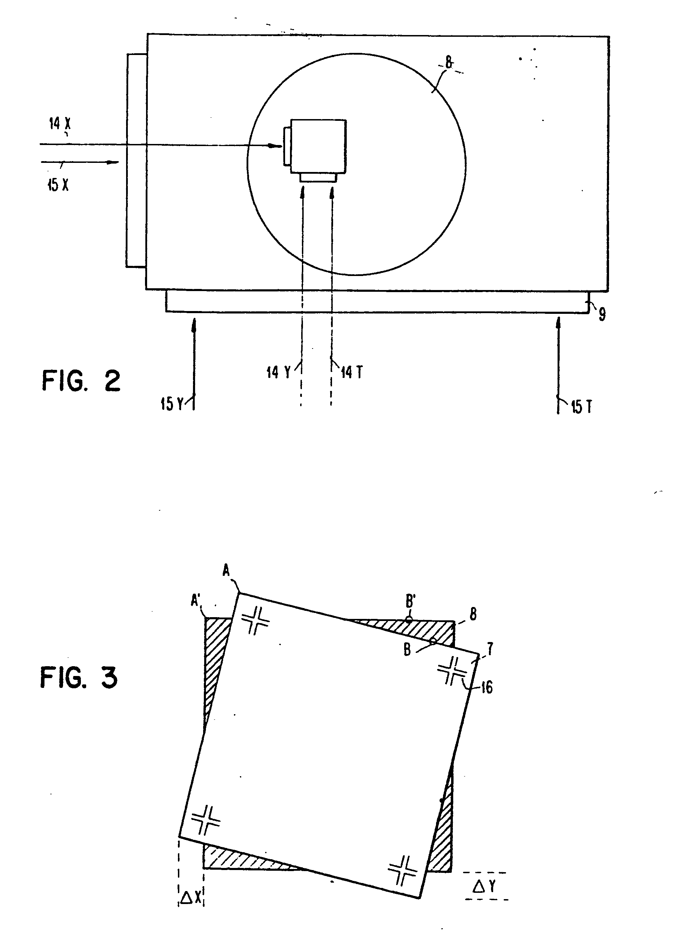

Die Interferometeranordnung 12 überwacht die Lage des Kreuzsupports 9, und somit auch des Halbleiterplättchens 8, und der Maske 7 in der aus Fig. 2 ersichtlichen Weise. Die in Fig. 1 mit 14 bezeichnete Schlangenlinie symbolisiert drei Interferometerachsen, von denen die erste 14X die Ausrichtung der Maske 7 in X-Richtung, die zweite 14Y die Ausrichtung der Maske in Y-Richtung und die dritte 14T im Zusammenwirken mit der zweiten den Drehfehler der Maske 7 überwacht. Die in Fig. 1 mit 15 bezeichnete Schlangenlinie symbolisiert drei weitere Interferometerachsen, von denen die erste 15X die Ausrichtung des Kreuzsupports 9 und somit auch des Halbleiterplättchens 8 in X-Richtung, die zweite 15Y die Ausrichtung des Kreuzsupports 9 bzw. des Halbleiterplättchens 8 in Y-Richtung und die dritte 15T im Zusammenwirken mit der zweiten den Drehfehler des Kreuzsupports 9 bzw. des Halbleiterplättchens 8 überwacht. Bei Verwendung größerer Masken ist es selbstverständlich auch möglich, den gesamten Maskenbereich in eine Vielzahl von Teilbereichen zu unterteilen, die in an sich bekannter Weise mit Ausrichtmarkierungen versehen sind. Durch entsprechende, auf dem Halbleiterplättchen angeordnete Ausrichtmarkierungen kann mit Hilfe des Elektronenstrahls 2 jeweils festgestellt werden, ob die jeweils zu belichtenden Teilbereiche des Halbleiterplättchens 8 mit den entsprechenden Teilbereichen der Maske 7 ausgerichtet sind.

Es ist nämlich möglich, daß aufgrund der durch die Beaufschlagung der Maske mit Elektronenstrahlen bedingten thermischen Belastung ein örtliches Kriechen einzelner Maskenbereiche stattfindet, so daß außer den durch die Interfero-meteranordnung 12 ermittelten Ausrichtfehlern zusätzliche, durch örtliches Kriechen einzelner Maskenbereiche verursachte Ausrichtfehler auftreten. Örtliche Ausrichtfehler können auch auf-grund örtlicher Versetzungen des Halbleiterplätt-chens 8 bedingt sein, die beispielsweise durch zwischen zwei aufeinanderfolgenden Belichtungen stattgefundene Wärmebehandlungen des Halbleiterplättchens 8 verursacht sein können.

In Fig. 3 ist die Maske 7 in bezug das Halbleiterplättchen 8 verdreht, was entweder durch die in den Fign. 1 und 2 dargestellte Interferometeranordnung 12 oder durch eine Abtastung der Ausrichtmarkierungen 16 festgestellt werden kann. Wie aus Fig. 3 ersichtlich, sollten bei einer genauen Übertragung der Maske 7 auf das Halbleiterplättchen 8 die Punkte A und B der Maske 7 auf die Punkte A′ bzw. B′ des Halbleiterplättchens 8 abgebildet werden. Diese Übertragung kann, einen gewissen Abstand zwischen Maske und Halbleiterplättchen vorausgesetzt, trotz des vorliegenden Ausrichtfehlers mit der in Fig. 1 dargestellten Vorrichtung dadurch erfolgen, daß der Elektronenstrahl 2 mit Hilfe der elektrostati-schen oder elektromagnetischen Ablenkvorrich-tung 6 bei der Abtastung der betreffenden Maskenpunkte um einen die örtliche Versetzung kompensierenden Winkel γ gekippt wird. Es ist leicht einzusehen, daß die in den einzelnen Bereichen aufgrund des Drehfehlers auftretenden Versetzungen Δx und Δy ortsabhängig sind und von dem aus der Interferometermessung bzw. aus der Abtastung der Ausrichtmarkierungen 16 be-kannten Winkel α wie folgt abhängen :

$$x = \alpha \cdot y$$

$$y = -\alpha \cdot x$$

wobei α, x und y jeweils die auf den Drehungsmittelpunkt bezogenen Koordinaten des die Maske abtastenden Elektronenstrahls sind. Die erforderlichen Korrekturen werden mit Hilfe der elektrostatischen oder elektromagnetischen Ablenkvorrichtung 6 der in Fig. 1 dargestellten Vorrichtung durch Kippung des Elektronenstrahls 2 um einen aufgrund des durch die Interferometeranordnung 12 oder durch die Abtastung der Ausrichtmarkierungen 16 ermittelten Drehfehlers α errechneten Winkel γ erreicht, der, wie leicht einzusehen, in einer senkrecht zur Ebene der Maske 7 liegenden und den Elektronenstrahl enthaltenden Ebene liegt. Die durch die Drehung der Maske 7 in bezug auf das Halbleiterplättchen 8 entstehenden Ausrichtfehler können selbstverständlich durch weitere, durch eine lineare Verschiebung der Maske 7 in bezug auf das Halbleiterplättchen 8 in X- und/oder Y-Richtung bedingte Ausrichtfehler überlagert sein.

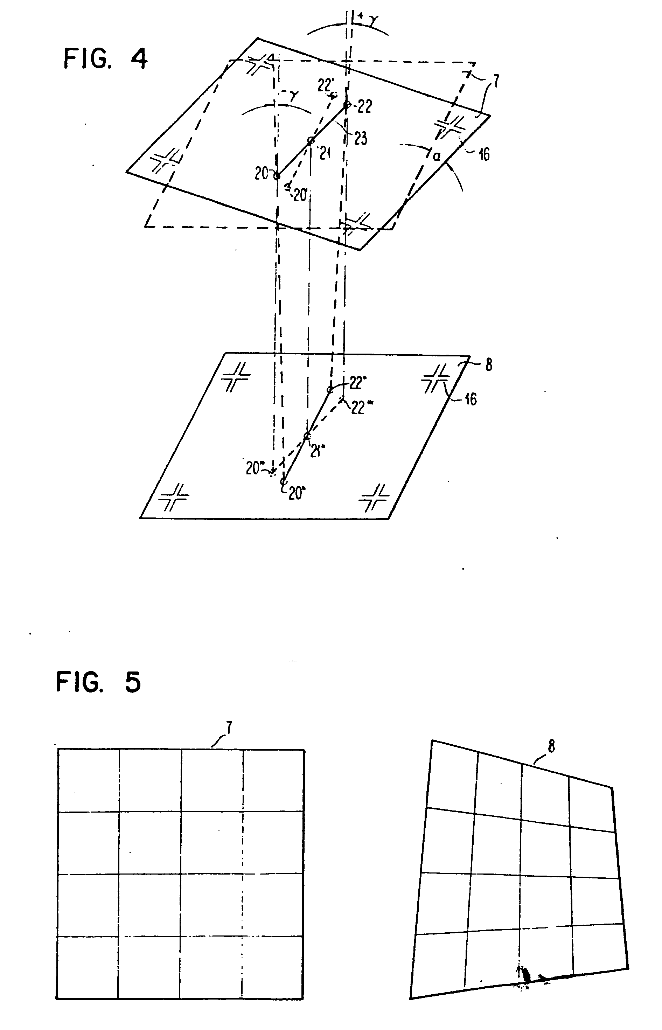

Die Verhältnisse bei der Korrektur eines durch eine Verdrehung der Maske 7 in bezug auf das Halbleiterplättchen 8 entstandenen Ausrichtfehlers werden anhand der Fig. 4 erläutert, die eine perspektivische Darstellung der Anordnung nach Fig. 3 wiedergibt, wobei der Abstand zwischen der Maske 7 und dem Halbleiterplättchen 8 zur Verdeutlichung vergrößert wiedergegeben ist. In der mit punktierten Linien dargestellten Soll-Lage der Maske 7 würden die zu übertragenden Ausnehmungen 20′, 21 und 22′ bei senkrechtem Einfall des Elektronenstrahls 2 in die mit 20″, 21″ und 22″ bezeichneten Bereiche des Halbleiterplättchens 8 übertragen. Bei einer in bezug auf die Soll-Lage um einen Winkel α gedrehte Maske 7, die in Fig. 4 mit ausgezogenen Linien dargestellt ist, würden die mit 20 und 22 bezeichneten Ausnehmungen der Maske 7 in die mit 20‴ und 22‴ bezeichneten Bereiche des Halbleiterplättchens 8 übertragen werden, die nicht in ihren Soll-Lagen liegen. Zur Übertragung der Ausnehmungen 20 und 22 der Maske 7 in die mit 20″ und 22″ bezeichneten Soll-Lagen muß der Elektronenstrahl 2 daher um einen Winkel − γ bzw. + γ in seine mit gestrichelten Linien dargestellten Lagen gekippt werden. Die Maskenöffnung 21, die im Drehpunkt der Maske liegt, wird in beiden eingezeichneten Lagen der Maske 7 bei senkrechtem Einfall des Elektronenstrahls in die Soll-Lage 21″ übertragen. Bei der Übertragung einer die Ausnehmungen 20 und 22 verbindenden Linie 23, müßte, wie leicht einzusehen, der Elektronenstrahl allmählich alle zwi-schen dem Winkel − γ und + γ liegenden Rich-tungen einnehmen, um die fehlerhafte Ausrichtung der Maske 7 in bezug auf das Halbleiterplättchen 8 unschädlich zu machen.

In Fig. 5 ist ein Halbleiterplättchen dargestellt, das nach einer Reihe von Heißprozessen durch in verschiedene Richtungen örtlich unterschiedliche lineare Längenänderungen eine nach allen Richtungen verlaufende Formänderung erfahren hat. Es ist ohne weiteres einzusehen, daß bei einer punktweisen Übertragung die in der Maske 7 enthaltenen, jedoch nicht dargestellten Strukturen auf das Halbleiterplättchen 8 in der Regel mit einem jeweils um entsprechende Winkel gekippten Elektronenstrahl übertragen werden müssen.

Da bei der Beaufschlagung einer Maske durch einen Elektronenstrahl notwendigerweise eine Erwärmung auftritt, die zu Verzeichnungen bei der Übertragung führen kann, sind besondere Maßnahmen erforderlich, um diese Erwärmung so gering wie möglich zu halten. Derartige Maßnahmen sind insbesondere bei der Benutzung von Komplementärmasken besonders wichtig, da bei derartigen Masken das Verhältnis der Flächen der Durchbrüche zu den Flächen der keine Durchbrüche aufweisenden Maskenbereiche besonders klein ist. Auch tritt insbesondere bei diesem Maskentyp eine besonders große Streuung der Flächen der Durchbrüche je Flächeneinheit der Maske auf.

Um die obengenannten Nachteile zu vermeiden, soll entweder die Abtastzeit klein gegenüber den Wärmeabklingzeiten sein oder das Abtastfeld in geeigneter Weise vom Strahl abgetastet werden.

Im ersten Fall überstreicht der Strahl die Maske so schnell, daß die Einstrahlung wie eine homogene Beaufschlagung mit einem auf die Maskendimension aufgeweiteten Flutstrahl wirkt. Diese Verhältnisse liegen beispielsweise vor, wenn die zur Abtastung eines die ganze Maskenfläche umfassenden Rasters erforderliche Zeit kleiner ist als die Abklingzeit. Dieses Verfahren vermeidet weitgehend lokale Temperaturspitzen und führt zu den kleinsten Temperaturerhöhungen.

Kann aus beleuchtungstechnischen Gründen die erforderliche Strahlungsdosis in einer so kurzen Abtastzeit nicht auf die Maske übertragen werden, so muß die Abtastung in geeigneter Weise räumlich und/oder zeitlich unterteilt werden. So kann es beispielsweise zweckmäßig sein, die Maske mit mehreren schnellen und jeweils nur einen Bruchteil der für die Übertragung erforderlichen Strahlungsdosis enthaltenden Abtastrastern zu beaufschlagen, deren Abtastzeit für sich allein jeweils kürzer als die Abklingzeit ist, die aber insgesamt die gesamte zur Belichtung erforderliche Strahlendosis enthalten. Einen ähnlichen Erfolg hätte auch eine Abtastung nach dem sogenannten Zeilensprungverfahren, bei dem ein Teilraster jeweils nur jede zweite, dritte usw. Abtastspur enthält.

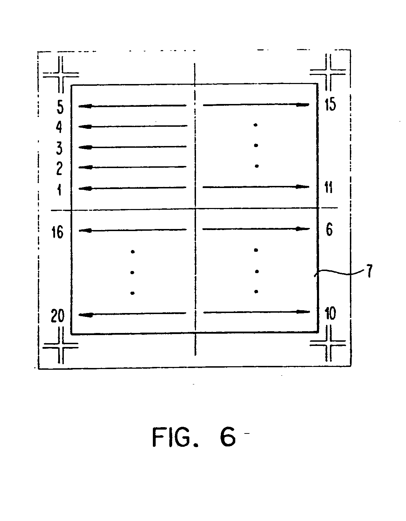

Aus Fig. 6 ist ein weiteres derartiges Abtastverfahren ersichtlich, bei dem das Abtastfeld in vier gleiche Felder unterteilt ist und die Abtastung in jedem Teilbereich von den Mittelachsen ausgehend zum Maskenrand verläuft. Hat die Abtastung bei diesem Verfahren den linken oberen Maskenrand erreicht, wurde die im Mittelbereich der Maske aufgestaute Wärme bereits über die verbleibenden, vom Elektronenstrahl nicht beaufschlagten Quadranten der Maske nach außen abgeführt. Die zweite Teilabtastung erfolgt, wie aus der Numerierung der Abtastspuren in Fig. 6 ersichtlich, im rechten unteren Teilbereich wieder von den beiden Mittelachsen der Achse ausgehend. Anschließend folgen die Abtastungen des oberen rechten und des unteren linken Teilbereichs der Maske. Diese Maßnahme kann selbstverständlich auch mit einem Zeilensprungverfahren der obengenannten Art oder mit dem ebenfalls obengenannten Verfahren der Belichtung mit mehreren aufeinanderfolgenden vollständigen Rastern kombiniert werden.

Da es wie weiter oben aufgeführt, im wesentlichen darauf ankommt, daß die örtlichen Temperaturen eine vorgegebene Höhe nicht überschreiten, kann es auch zweckmäßig sein, die Wärmekapazität der Maske zu erhöhen so daß die Temperatur der bei einer bestimmten Strahlendosis auf die Maske übertragenen Wärme einen vorbestimmten Betrag nicht übersteigt. Zu diesem Zweck wird vorgeschlagen, die Maske in Lamellenbauweise auszuführen. Als besonders vorteilhaft haben sich in diesem Zusammenhang Silizium-Dünnfilmmasken mit einem dicken Goldauftrag erwiesen.

Die zuletztgenannten Maßnahmen zur Vermeidung einer zu hohen thermischen Belastung der Masken sind selbstverständlich nicht nur auf die Verwendung im Zusammenhang mit der Schattenwurfbelichtung durch Korpuskularstrahlen beschränkt. Sie können vielmehr mit Erfolg bei jeder Belichtung verwendet werden, bei der eine Maske durch einen Strahl punktweise abgetastet wird.

**Ansprüche**

1. Verfahren zur Belichtung strahlungsempfindlicher Schichten (8) durch Schattenwurfprojektion eines Maskenmusters mit folgenden Verfahrens-Merkmalen :

a) es wird ein Korpuskularstrahlenbündel (2) verwendet, das um einen in oder in der Nähe der Ebene der Maske (7) liegenden Punkt kippbar ist,

b) das Korpuskularstrahlenbündel (2) weist einen Querschnitt auf, der wesentlich kleiner ist als das bei einer gegebenen Relativlage von Maske (7) und strahlungsempfindlicher Schicht (8) zu projizierende Maskenmuster,

c) das Korpuskularstrahlenbündel (2) wird zur abschnittsweisen Belichtung nacheinander über das gesamte zu projizierende Maskenmuster geführt,

d) der Kippwinkel des Korpuskularstrahlenbündels (2) wird bedarfsweise bei jeder Belichtungsposition zur Kompensation lokaler Ausrichtfehler verändert.

2. Verfahren nach Anspruch 1, dadurch gekennzeichnet, daß der je Teilbereich der durch den Korpuskularstrahl abzutastenden Maskenfläche ermittelte Ausrichtfehler als Grundlage für die Berechnung des diesen Fehler im jeweiligen Teilbereich der Maske kompensierenden Kippwinkels γ des Elektronenstrahls verwendet wird.

3. Verfahren nach Anspruch 1, dadurch gekennzeichnet, daß der Ausrichtfehler für einen größeren Maskenbereich ermittelt wird, die sich daraus für die einzelnen Teilmaskenbereiche ergebenden Ausrichtfehler errechnet werden und zur Grundlage der Berechnung der für die Kompensation der in den einzelnen Teilbereichen vorliegenden Ausrichtfehler erforderlichen Kippungen des Elektronenstrahls dienen.

4. Verfahren nach den Ansprüchen 1, 2 und/oder 3, dadurch gekennzeichnet, daß die Ermittlung der Ausrichtfehler zwischen Maske und zu belichtendem Halbleiterplättchen durch interferometrische Messung erfolgt.

5. Verfahren nach den Ansprüchen 1, 2 und/oder 3, dadurch gekennzeichnet, daß die Ermittlung des Ausrichtfehlers zwischen Maske und zu belichtendem Halbleiterplättchen durch die Abtastung von Ausrichtmarkierungen erfolgt.

6. Verfahren nach einem oder mehreren der vorhergehenden Ansprüche, dadurch gekennzeichnet, daß zur Berechnung der zur Kompensation der örtlichen Ausrichtfehler erforderlichen Kippungen des Elektronenstrahls um einen in oder in der Nähe der Maskenebene liegenden Punkt auch der jeweilige Abstand zwischen Maske und Halbleiterplättchen berücksichtigt wird.

7. Verfahren nach einem der Ansprüche 1 bis 6, dadurch gekennzeichnet, daß die Zeit zur Abtastung des zu projizierenden Maskenmusters klein ist im Vergleich zur Wärmeabklingzeit.

8. Verfahren nach einem der Ansprüche 1 bis 7, dadurch gekennzeichnet, daß die zur Belichtung erforderliche Strahlendosis durch mehrere in zeitlicher Aufeinanderfolge durchgeführte schnelle Rasterabtastungen übertragen wird, die jeweils einen entsprechenden Bruchteil der erforderlichen Dosis enthalten.

9. Verfahren nach einem der Ansprüche 1 bis 7, dadurch gekennzeichnet, daß die Abtastung im Zeilensprungverfahren erfolgt, das heißt, daß zunächst jede zweite, dritte, vierte usw. Zeile abgetastet und anschließend in aufeinanderfolgenden Abtastungen jeweils die Zwischenzeilen abgetastet werden.

10. Verfahren nach einem der Ansprüche 1 bis 7, dadurch gekennzeichnet, daß die Maske durch Teilraster abgetastet wird, die jeweils von der Mitte des abzutastenden Gesamtbereichs ausgehen.

11. Vorrichtung zur Durchführung des Verfahrens nach einem der Ansprüche 1 bis 10, gekennzeichnet durch eine Elektronenstrahlquelle (1) zur Erzeugung eines Elektronenstrahls (2), eine Kollimatorlinse (3), eine Austastvorrichtung (4) zur steuerbaren Unterdrückung bzw. Freigabe des Elektronenstrahls, eine elektromagnetische Ablenkvorrichtung (5) zur periodischen Ablenkung des Elektronenstrahls entlang eines Abtastrasters, eine elektrostatische oder elektromagnetische Ablenkvorrichtung (6) zur steuerbaren Kippung des Elektronenstrahls um einen in der oder in der Nähe der Maskenebene Liegenden Punkt um einen als Funktion des jeweils ermittelten Ausrichtfehlers berechneten Winkel $\gamma$, einen Kreuzsupport (9) zur Halterung eines Halbleiterplättchens (8) sowie durch eine interferometrische Anordnung (12) zur Emittlung der Lagen der Maske (7) und des Halbleiterplättchens (8), durch einen Ablenkgenerator (10) zur periodischen Ablenkung des Elektronenstrahls entlang den Spuren eines Abtastrasters, durch einen Kippgenerator (11) zur Steuerung der elektrostatischen oder elektromagnetischen Ablenkvorrichtung (6) sowie durch einen Computer (13) zur Umwandlung der ermittelten Ausrichtfehler zwischen der Maske (7) und dem Halbleiterplättchen (8) in Steuerbefehle für den Kippgenerator (11).

12. Vorrichtung nach Anspruch 11, dadurch gekennzeichnet, daß die Maske zwecks Erhöhung der Wärmekapazität in Lamellenbauweise ausgeführt ist.

13. Vorrichtung nach Anspruch 12, dadurch gekennzeichnet, daß die Maske als Silizium-Dünnfilmmaske mit einem dicken Goldauftrag ausgebildet ist.

## Claims

1. Method of exposing photosensitive layers (8) through shadow printing projection of a mask pattern, with the following process features :

a) a corpuscular beam (2) is used which is tiltable by a point in, or near to, the plane of the mask (7),

b) the corpuscular beam (2) has a cross-section which is much smaller than the mask pattern to be projected in a given relative position of mask (7) and a photosensitive layer (8),

c) for the section-wise exposure the corpuscular beam (2) is successively guided over the entire mask pattern to be projected,

d) the tilting angle of the corpuscular beam (2) is altered, if necessary, at each exposure position to compensate local alignment errors.

2. Method as claimed in claim 1, characterized in that the alignment error found for each sub-area of the mask surface to be scanned by the corpuscular beam, is used as a basis for calculating the tilting angle $\gamma$ of the electron beam compensating this error in the respective sub-area of the mask.

3. Method as claimed in claim 1, characterized in that the alignment error is found for a large mask area, that the alignment errors resulting therefrom for the individual mask sub-areas are calculated, and serve as a basis for calculating the tiltings of the electron beam required for compensating the alignment errors in the various sub-areas.

4. Method as claimed in claims 1, 2 and/or 3, characterized in that the alignment errors between mask and semiconductor chip to be exposed are detected by interferometric measuring.

5. Method as claimed in claims 1, 2 and/or 3, characterized in that the alignment error between mask and semiconductor chip to be exposed is found by the scanning of alignment marks.

6. Method as claimed in one or several of the preceding claims, characterized in that for calculating the electron beam tiltings for the compensation of the local alignment errors, about a point in, or near to, the mask plane the respective distance between mask and semiconductor chip is also considered.

7. Method as claimed in any one of claims 1 to 6, characterized in that the time for scanning the mask pattern to be projected is short compared with the heat decay period.

8. Method as claimed in any one of claims 1 to 7, characterized in that the radiation dosage required for exposure is transferred through several successive high-speed raster scannings each containing a corresponding fraction of the required dosage.

9. Method as claimed in any one of claims 1 to 7, characterized in that scanning is effected by interlaced scanning, i.e. first each second, third, fourth etc. line is scanned, and subsequently the respective intermediate lines are scanned successively.

10. Method as claimed in any one of claims 1 to 7, characterized in that the mask is scanned by partial rasters each starting from the center of the whole area to be scanned.

11. Device for carrying out the method as claimed in any one of claims 1 to 10, characterized by an electron beam source (1) for generating an electron beam (2), a collimator lens (3), a blanking device (4) for controllably suppressing or releasing the electron beam, an electromagnetic deflector (5) for periodically deflecting the electron beam along a scanning raster, an electrostatic or electromagnetic deflector (6) for controllably tilting the electron beam about a point in, or near to, the mask plane by an angle $\gamma$ calculated as a function of the respective alignment error, an XY-table (9) supporting a semiconductor chip (8) and by an interferometric arrangement (12) for determining the positions of the mask (7) and of the semiconductor chip (8), by a deflection generator (10) for periodically deflecting the electron beam along the tracks of a scanning raster, by a tilting generator (11) for controlling the electrostatic or electromagnetic deflector (6), as well as by a computer (13) for converting the alignment errors found between the mask (7) and the semiconductor chip (8) into control instructions for the tilting generator (11).

12. Method as claimed in claim 11, characterized in that for increasing the heat capacity the mask is designed as a laminated structure.

13. Device as claimed in claim 12, characterized in that the mask is designed as a silicon thin film mask carrying a thick gold coating.

## Revendications

1. Procédé pour exposer des couches (8) sensibles au rayonnement par projection d'ombre d'une configuration de masque ayant les caractéristiques de procédés suivantes :

a) on utilise un faisceau de rayons corpusculaires (2) qui peut être basculé autour d'un point dans le plan du masque (7) ou près de celui-ci,

b) le faisceau de rayons corpusculaires (2) a une coupe transversale qui est considérablement plus petite que la configuration de masque à projeter à une position relative donnée du masque (7) et de la couche sensible au rayonnement (8),

c) on fait passer le faisceau de rayons corpusculaires (2) sur toute la configuration de masque à projeter pour une exposition section par section,

d) si nécessaire, on modifie l'angle d'inclinaison du faisceau de rayons corpusculaires (2) à chaque position d'exposition pour compenser des erreurs d'alignement locales.

2. Procédé selon la revendication 1, caractérisé en ce qu'on utilise l'erreur d'alignement détectée pour chaque région partielle de la surface de masque devant être balayée par les rayons corpusculaires comme base pour calculer l'angle d'inclinaison $\gamma$ du faisceau électronique compensant cette erreur dans la région partielle respective du masque.

3. Procédé selon la revendication 1, caractérisé en ce qu'on détecte l'erreur d'alignement pour une région de masque plus étendue, et en ce qu'on calcule les erreurs d'alignement qui en résulte pour les différentes régions partielles de masque qui servent de base pour calculer les basculement du faisceau électronique nécessaires pour compenser les erreurs d'alignement survenant dans les différentes régions partielles.

4. Procédé selon les revendications 1, 2 et/ou 3, caractérisé en ce qu'on détermine les erreurs d'alignement entre le masque et la microplaquette semi-conductrice à exposer par une mesure interférométrique.

5. Procédé selon les revendications 1, 2 et/ou 3, caractérisé en ce qu'on détermine l'erreur d'alignement entre le masque et la microplaquette semi-conductrice à exposer en balayant des marques d'alignement.

6. Procédé selon l'une quelconque ou plusieurs des revendications précédentes, caractérisé en ce qu'on tient également compte de la distance respective entre le masque et la microplaquette semi-conductrice pour calculer les basculements du faisceau électronique, nécessaires pour compenser les erreurs d'alignement locales, autour d'un point dans le plan du masque ou à proximité de celui-ci.

7. Procédé selon l'une quelconque des revendications 1 à 6, caractérisé en ce que le temps de balayage de la configuration de masque à projeter est petit en comparaison du temps de diminution de chaleur.

8. Procédé selon l'une quelconque des revendications 1 à 7, caractérisé en ce qu'on transfère le dosage de radiation nécessaire pour l'exposition par plusieurs balayages de trames rapides se suivant dans le temps, chaque balayage contenant une fraction correspondante du dosage requis.

9. Procédé selon l'une quelconque des revendications 1 à 7, caractérisé en ce que le balayage est exécuté par entrelaçage de lignes, c'est-à-dire qu'on balaie d'abord chaque seconde, troisième, quatrième ligne, etc. et qu'on balaie ensuite les lignes intermédiaires respectives par des balayages successifs.

10. Procédé selon l'une quelconque des revendications 1 à 7, caractérisé en ce qu'on balaie le masque à l'aide de trames partielles, chacune partant du milieu de l'ensemble de la région à balayer.

11. Dispositif pour exécuter le procédé selon l'une des revendications 1 à 10, caractérisé en ce qu'il comporte : une source de faisceau électronique (1) pour générer un faisceau électronique (2), une lentille de collimateur (3), un dispositif de balayage (4) pour pouvoir commander la suppression ou respectivement le déclenchement du faisceau électronique, un déflecteur magnétique (5) pour la déflexion périodique du faisceau électronique le long d'une trame de balayage, un déflecteur électrostatique ou électromagnétique (6) pour pouvoir commander le basculement du faisceau électronique autour d'un point dans le plan de masque ou à proximité de celui-ci selon un angle $\gamma$ calculé comme une fonction de l'erreur d'alignement respective déterminée, un support en croix (9) pour maintenir une microplaquette semiconductrice (8) ainsi qu'un dispositif interférométrique (12) pour déterminer les positions du masque (7) et de la microplaquette semiconductrice (8), un générateur de déflexion (10) pour la déflexion périodique du faisceau électronique le long des pistes d'une trame de balayage, un générateur de bascule (11) pour commander le déflecteur électrostatique ou électromagnétique (6) ainsi qu'un ordinateur (13) pour convertir les erreurs d'alignement déterminées entre le masque (7) et la microplaquette semi-conductrice (8) en instructions de commande pour le générateur de bascule (11).

12. Dispositif selon la revendication 11, caractérisé en ce que le masque a une structure en lamelles pour augmenter la capacité thermique.

13. Dispositif selon la revendication 12, caractérisé en ce que le masque forme un masque de film mince de silicium revêtu par un dépôt d'or épais.

FIG. 1

FIG. 2

FIG. 3

FIG. 4

FIG. 5

FIG. 6